Europäisches Patentamt

European Patent Office

Office européen des brevets

(19)

(11) **EP 0 881 500 B1**

(12) **FASCICULE DE BREVET EUROPEEN**

(45) Date de publication et mention
de la délivrance du brevet:
**29.01.2003 Bulletin 2003/05**

(51) Int Cl.[7]: **G01R 27/16**

(21) Numéro de dépôt: **97401207.2**

(22) Date de dépôt: **30.05.1997**

(54) **Procédé pour la mesure de l'impédance de boucle d'un réseau d'alimentation en courant avec conducteur neutre**

Messverfahren zur Messung der Schleifenwiderstandes eines Stromversorgungsnetzes mit Nulleitern

Procedure for measuring the loop-impedance of an electric distribution network comprising a neutral conductor

(84) Etats contractants désignés:
**AT CH DE ES GB IT LI**

(43) Date de publication de la demande:
**02.12.1998 Bulletin 1998/49**

(73) Titulaire: **CHAUVIN ARNOUX**
**75018 Paris (FR)**

(72) Inventeurs:
 • **Arnoux, Axel**
  **75018 Paris (FR)**
 • **Genter, Claude**
  **75018 Paris (FR)**
 • **Piaud, Didier**
  **92370 Chaville (FR)**
 • **Kadecka, Thomas**
  **A-1230 Wien (AT)**

(74) Mandataire: **Berger, Helmut et al**
 **Cabinet WEINSTEIN**
 **56 A, rue du Faubourg Saint-Honoré**
 **75008 Paris (FR)**

(56) Documents cités:
 **EP-A- 0 295 800          GB-A- 2 268 811**

## Description

La présente invention concerne un procédé pour la mesure de l'impédance de boucle d'un réseau d'alimentation en courant, du type comprenant un dispositif disjoncteur de sécurité et de protection contre des courants de défaut, un conducteur neutre et un conducteur de protection par mise à la terre, selon le préambule de la revendication 1.

Des procédés de ce genre sont déjà connus. Dans la pratique, ces mesures rencontrent cependant des difficultés parce que dans la partie de l'installation dans laquelle il faut effectuer les mesures, les usagers ne peuvent pas être complètement déconnectés et par conséquent, des perturbations sont occasionnées par la connexion et la déconnexion de charges pendant la mesure. Ces changements de charge perturbent sensiblement les résultats de mesure pour l'établissement de l'impédance de boucle, parce que les variations de courant dues à des processus de commutation sont de l'ordre du courant injecté ou supérieures. Pour obtenir un résultat utilisable pour l'impédance de boucle, il convient de mesurer avec un courant de charge le plus élevé possible. Dans des réseaux qui sont protégés par des disjoncteurs de sécurité et de protection contre des courants de défaut, le courant de mesure ne doit cependant pas dépasser la moitié du courant de déclenchement des disjoncteurs de sécurité, en raison du risque de déclencher ces disjoncteurs, ce qui entraînerait la déconnexion des usagers connectés et rendrait impossible tout résultat de mesure fiable.
Un procédé de mesure pour un réseau protégé par des disjoncteurs est décrit dans le document EP-A-0295 800. L'invention a pour but de proposer un procédé qui ne présente pas les inconvénients du procédé connu.

Le but est atteint grâce aux caractéristiques qui sont énoncées dans la partie caractérisante de la revendication 1.

D'autres caractéristiques de l'invention figurent dans des revendications dépendantes.

On décrira ci-après, de façon plus détaillée, l'invention en se référant à des dessins annexés sur lesquels :

- La figure 1 montre le principe d'un système de mesure dans un réseau du type TT, et

- La figure 2 montre le principe d'un système de mesure dans un réseau du type TN-C-S.

Avant la description des systèmes de mesure, on rappellera que la première lettre de la définition du réseau concerne les conditions de la mise à la terre de la source de courant et la deuxième lettre les conditions de la mise à la terre des corps de l'installation électrique. La première lettre T indique une mise à la terre directe d'un point (prise de terre du système). Comme deuxième lettre, T indique que le corps est directement mis à la terre (prise de terre de l'installation), cependant indépendamment d'une mise à la terre, le cas échéant existant, d'un point de la source de courant. La lettre N signifie que le corps est directement relié à la prise de terre du système de la source de courant. Les autres lettres S et C concernent la disposition du conducteur neutre et du conducteur de protection par mise à la terre. S indique que le conducteur L et le conducteur de protection sont réalisés sous forme de conducteurs séparés et C indique que les fonctions du conducteur neutre et du conducteur de protection par mise à la terre sont combinées en un seul conducteur.

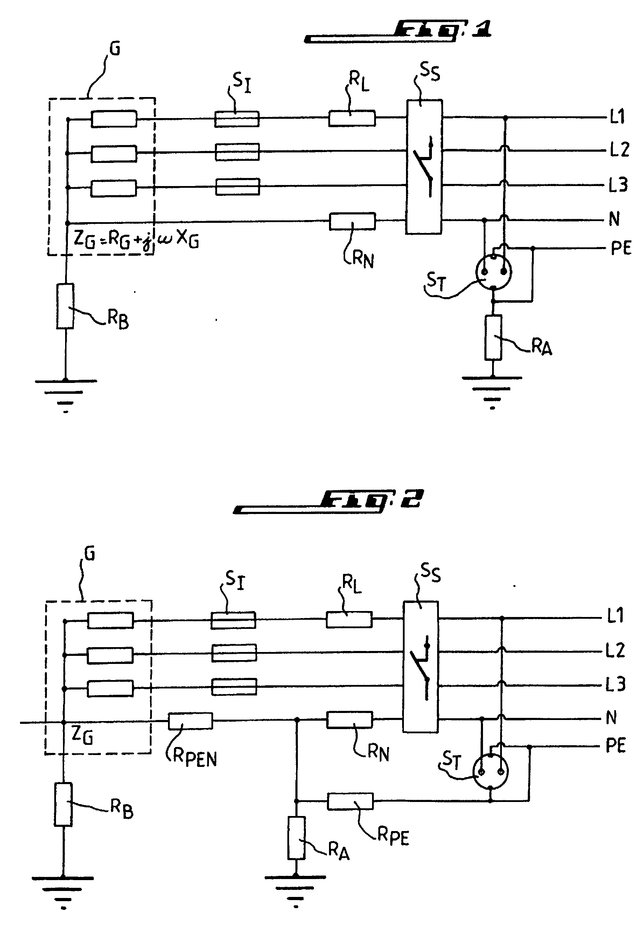

Sur les figures 1 et 2, qui montrent respectivement un réseau du type TT et un réseau du type TN-C-S, G désigne un générateur avec une impédance de générateur $Z_G$ ayant une résistance effective $R_G$ et une résistance apparente $wX_G$, L1, L2 et L3 les conducteurs de phase du réseau, N le conducteur neutre et $P_E$ le conducteur de protection par mise à la terre. Le réseau est pourvu de disjoncteurs de protection, c'est-à-dire de disjoncteurs de protection contre les courants de défaut, qui portent la référence $S_S$. Dans chaque conducteur de phase L1, L2, L3 est monté un fusible Si. Les symboles de référence $R_L$ et $R_N$ désignent respectivement la résistance spécifique du conducteur de phase L1, et la résistance spécifique du conducteur neutre N. Par ST est désignée une prise de courant qui est montée entre le conducteur N et le conducteur de phase L1. Cette prise de courant peut servir pour l'injection du courant de mesure et pour le raccordement d'un usager.

Le générateur G est mis à la terre et $R_B$ désigne la résistance de la prise de terre du système. La prise de courant ST est également mise à la terre et la résistance de la prise de terre d'installation est désignée par $R_A$.

Selon les définitions susmentionnées, dans le réseau du type TT de la figure 1, la prise de terre du système et la prise de terre de l'installation sont indépendantes l'une de l'autre.

Dans le réseau du type TN-C-S selon la figure 2, le conducteur de protection PE et le conducteur neutre N sont réunis dans la partie gauche du réseau pour former le conducteur PEN dont la résistance est désignée par $R_{PEN}$. $R_{PE}$ constitue la résistance spécifique du conducteur PE et est en série avec la résistance de la prise de terre d'installation $R_A$, la borne commune aux deux résistances étant reliée à la borne commune des résistances $R_{PEN}$ et $R_N$.

L'impédance de boucle dont l'établissement est l'objet de la présente invention s'obtient comme somme de toutes les impédances.

Dans le réseau TT sur la figure 1, on obtient pour l'impédance de boucle :

$$Z_S = Z_G + R_L + R_B + R_A$$

Dans le réseau TN-C-S de la figure 3 on obtient comme impédance de boucles :

$$Z_S = Z_G + R_L + R_{PEN}' + R_{PE}$$

Où $R_{PEN}'$ est la résistance de l'ensemble $\pi$ qui est formé par la résistance $R_{PE}$, $R_A$ et $R_B$.

Le procédé selon l'invention pour l'établissement c'est-à-dire la mesure de l'impédance de boucle dans les deux réseaux implique deux mesures partielles.

Pour la première mesure on injecte entre un conducteur de phase, c'est-à-dire un des conducteurs L1 à L3, et le conducteur N un courant le plus élevé possible et on mesure la variation de la tension entre le conducteur de phase et le conducteur de protection par mise à la terre PE, dans le réseau chargé par le courant injecté et le réseau non chargé. On obtient :

$$Z_{S1} = \frac{U_o(L - PE) - U_{BEL}(L - PE)}{I_{BEL}(L - N)}$$

Où $U_O(L - PE)$ désigne la tension de marche à vide entre L et PE, $U_{BEL}(L - PE)$ la tension sous charge entre L et PE et $I_{BEL(L-N)}$ le courant injecté entre L et N.

Au cours de la première mesure le courant peut être élevé parce que le dispositif disjoncteur de protection Fi n'est pas excité parce qu'à l'intérieur de ce dispositif, les champs magnétiques produits par les courants s'écoulant à travers ses enroulements s'annulent.

Ensuite on effectue une deuxième mesure au cours de laquelle on injecte entre le conducteur de phase et le conducteur PE un courant qui ne déclenche pas encore les disjoncteurs de protection Fi. Ensuite on mesure le changement de tension entre N et PE dans le réseau chargé par le courant injecté et le réseau non chargé. Un deuxième résultat partiel de l'impédance de boucle s'obtient de l'équation suivante :

$$R_{S2} = \frac{U_o(N - PE) - U_{BEL}(N - PE)}{I_{BEL}(L - PE)}$$

Où $I_{BEL(L-PE)}$ désigne le courant injecté entre le conducteur de phase et le conducteur PE.

L'impédance de boucle $Z_S$ s'obtient comme somme des résultats partiels $Z_{S1}$ et $R_{S2}$ qu'ont procurés les deux mesures :

$$Z_S = Z_{S1} + R_{S2}.$$

On peut prouver à l'aide des figures 1 et 2 que la somme des résultats partiels des deux mesures donne réellement l'impédance de boucle. Dans le réseau TT de la figure 1, l'impédance de boucle $Z_S$ et les impédances partielles $Z_{S1}$ et $R_{S2}$ peuvent être exprimées de la manière suivante :

$$Z_S = Z_G + R_L + R_B + R_A$$

$$Z_{S1} = Z_G + R_L$$

$$R_{S2} = R_A + R_B$$

On constate que la somme de $Z_{S1}$ et $R_{S2}$ donne en effet l'impédance de boucle $Z_S$.

Dans le réseau TN-C-S de la figure 2 on obtient :

$$Z_S = Z_G + R_L + R_{PEN}' + R_B$$

Où $R_{PEN}'$ est, comme déjà mentionné, la résistance de l'ensemble $\pi$ qui est formé par la résistance $R_{PEN}$, $R_A$ et $R_B$.

$$Z_{S1} = Z_G + R_L + R_{PEN}'$$

$$R_{S2} = R_{PE}$$

Ici aussi la somme des résultats partiels de l'impédance de boucle donne cette impédance de boucle $Z_S$.

## Revendications

**1.** Procédé pour la mesure de la résistance de boucle d'un réseau d'alimentation en courant, comprenant un conducteur neutre (N), un conducteur de protection par mise à la terre (PE) et un dispositif de protection contre des courants de défaut, selon lequel l'impédance de boucle est formée par division de la tension de différence par un courant injecté, établie dans le réseau chargé par le courant injecté et le réseau non chargé, **caractérisé en ce que** l'on effectue une première mesure au cours de laquelle un courant est injecté entre un conducteur de phase (L1, L2, L3) et le conducteur neutre (N), le changement de tension entre le conducteur de phase et le conducteur de protection par mise à la terre (PE) est mesuré, dans le réseau chargé par le courant injecté et le courant non chargé, que l'on effectue une seconde mesure au cours de laquelle un courant est injecté entre un conducteur de phase (L1, L2, L3) et le conducteur de protection par mise à la terre (PE), qui ne déclenche justement pas encore le dispositif de protection (SS), et qu'on détermine le changement de la tension entre le conducteur neutre (N) et le conducteur de protection par mise à la terre (PE) dans le réseau chargé par le courant injecté et le réseau non chargé, et que l'impédance de boucle est établie comme somme des résistances qui sont formées aux deux mesures à partir de la tension de différence respective et le courant injecté respectif.

## Patentansprüche

1. Verfahren zum Messen des Schleifen-Widerstands eines Stromversorgungsnetzes, umfassend einen Neutralleiter (N), einen Erdungsschutzleiter (PE) und eine Vorrichtung zum Schutz gegen Fehlerströme, bei dem die Schleifenimpedanz durch Teilung der Differenzspannung durch einen eingeleiteten Strom gebildet wird, die an das mit dem eingeleiteten Strom belastete Netz und an das nicht belastete Netz angelegt wird, **dadurch gekennzeichnet, dass** eine erste Messung erfolgt, während der ein Strom zwischen einem Phasenleiter (L1, L2, L3) und dem Neutralleiter (N) eingeleitet wird, der Spannungswechsel zwischen dem Phasenleiter und dem Erdungsschutzleiter (PE) im mit dem eingeleiteten Strom belasteten Netz und im nicht belasteten Netz gemessen wird, dass eine zweite Messung erfolgt, während der ein Strom zwischen einem Phasenleiter (L1, L2, L3) und dem Erdungsschutzleiter (PE) eingeleitet wird, der die Schutzvorrichtung (SS) gerade noch nicht auslöst, und dass der Spannungswechsel zwischen dem Neutralleiter (N) und dem Erdungsschutzleiter (PE) im mit dem eingeleiteten Strom belasteten Netz und im nicht belasteten Netz ermittelt wird, und dass die Schleifenimpedanz als Summe der Widerstände angelegt wird, die bei den beiden Messungen ausgehend von der jeweiligen Differenzspannung und dem jeweiligen eingeleiteten Strom gebildet werden.

## Claims

1. Method for measuring the loop resistance of a current supply network, comprising a neutral conductor (N), an earthing-protection conductor (PE) and a protection device which protects from fault currents, in which the loop impedance is formed by dividing the voltage difference by an injected current, established in the network loaded by the injected current and the unloaded network, **characterized in that** a first measurement is made during which a current is injected between a phase conductor (L1, L2, L3) and the neutral conductor (N), the change in voltage between the phase conductor and the earthing-protection conductor (PE) is measured, in the network loaded by the injected current and the unloaded current [sic], **in that** a second measurement is made during which a current is injected between a phase conductor (L1, L2, L3) and the earthing-protection conductor (PE), which just does not yet trip the protection device (SS), and **in that** the change in the voltage between the neutral conductor (N) and the earthing-protection conductor (PE), in the network loaded by the injected current and the unloaded network, is determined and **in that** the loop impedance is established as the sum of the resistances which are formed at the two measurements from the respective difference voltage and the respective injected current.

FIG. 1

FIG. 2

5